(19) Europäisches Patentamt / European Patent Office / Office européen des brevets

(11) **EP 1 575 157 B1**

(12) **EUROPEAN PATENT SPECIFICATION**

(45) Date of publication and mention
of the grant of the patent:
**08.10.2008 Bulletin 2008/41**

(51) Int Cl.:
***H01L 41/04*** (2006.01)     ***H02N 2/06*** (2006.01)

(21) Application number: **03778796.7**

(86) International application number:
**PCT/JP2003/015840**

(22) Date of filing: **11.12.2003**

(87) International publication number:
**WO 2004/055966 (01.07.2004 Gazette 2004/27)**

(54) **DRIVER FOR PIEZOELECTRIC ACTUATORS**

TREIBER FÜR PIEZOELEKTRISCHE AKTUATOREN

DISPOSITIF DE COMMANDE D'ACTIONNEURS PIÉZO-ÉLECTRIQUES

(84) Designated Contracting States:
**DE ES FR GB IT TR**

(30) Priority: **16.12.2002  JP 2002363294**

(43) Date of publication of application:
**14.09.2005  Bulletin 2005/37**

(73) Proprietors:
- **Wac Data Service Kabushiki Kaisha
  Fujimi-shi,
  Saitama-ken 354-0018 (JP)**
- **CDK CO., LTD.
  Higashimatuyama-Shi,
  Saitama 355-0028 (JP)**

(72) Inventors:
- **Watanabe, Kazuhisa
  Fujimi-Shi,
  Saitama 354-0018 (JP)**
- **Enomoto, Satoshi
  Higashimatsuyama-Shi,
  Saitama 355-0028 (JP)**
- **Enomoto, Hiroshi
  Higashimatsuyama-Shi,
  Saitama 355-0028 (JP)**
- **Kanai, Shigeru
  Fujimi-Shi,
  Saitama 354-0018 (JP)**
- **Takane, Toshiaki
  Fujimi-Shi,
  Saitama 354-0018 (JP)**

(74) Representative: **Kramer - Barske - Schmidtchen
European Patent Attorneys
Landsberger Strasse 300
80687 München (DE)**

(56) References cited:
EP-A2- 1 079 447          WO-A-94/27330
JP-A- 5 206 537           JP-A- 5 302 251
JP-A- 7 141 028           JP-A- 8 218 255
JP-A- 10 000 773          JP-A- 2002 113 864
US-A1- 2001 035 696

## Description

### Technical Field

The present invention relates to a driver of a piezoelectric actuator, and particularly to improvement in the driver of the piezoelectric actuator for switching and driving a plurality of piezoelectric actuators mechanically moving each of the plural mechanism components directly or indirectly installed on the driver.

### Background Art

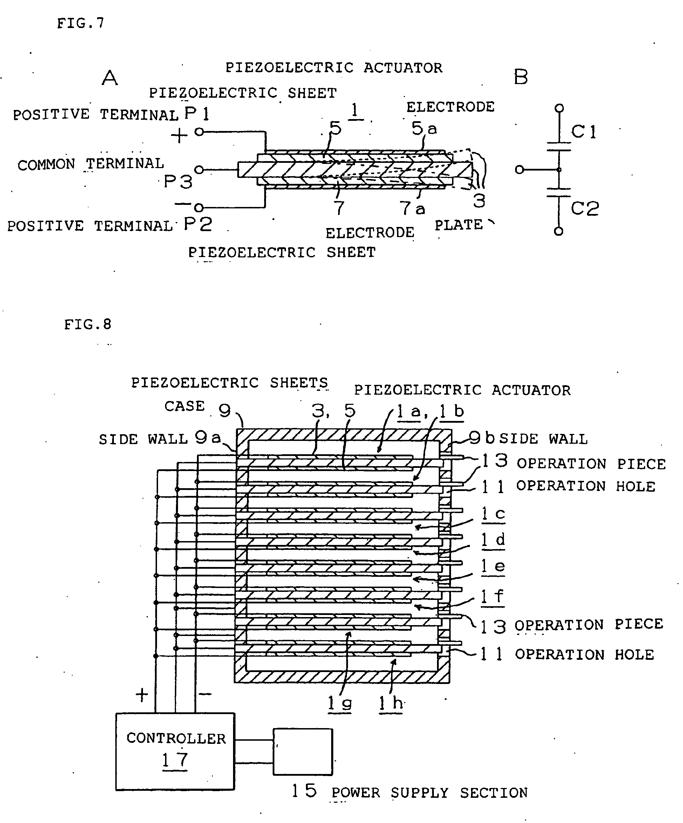

Conventionally, as shown in Fig.7A, a piezoelectric actuator 1 is constituted in such a manner that thin piezoelectric sheets 5 and 7 are attached to opposed surfaces of a rectangular conductive plate 3, and electrodes 5a and 7a are disposed on the opposed surfaces which are not brought into contact with the plate 3 in each piezoelectric sheet 5 and 7, with the plate 3 serving as common electrodes, wherein the electrodes 5a and 7a are connected to positive terminals P1 and negative terminals P2, the plate 3 is connected to a common terminal P3, and while supporting one end (left end in the figure) in the longitudinal directions of the plate 3 in an open-sided shape, the other end (right end in the figure) is formed in an open end. Note that a support member of the piezoelectric actuator 1 is not shown in Fig. 7 (see Fig.8).

In the piezoelectric actuator 1 thus constituted, for example, when positive potential + is applied to a positive terminal P1 and a common terminal P3 by short-circuiting both terminals (between the electrode 5a of the piezoelectric sheet 5 and the plate 3), according to the polarization directions of the piezoelectric sheets 5 and 7, for example, the plate 3 is bent so that the open end is displaced in the upward direction as shown by broken line in Fig.7A.

Meanwhile, when a negative potential - is applied to the common terminal P3 and a negative terminal P2 by short-circuiting both terminals (between the plate 3 and the electrode 7a of the other piezoelectric sheet 7), for example, the open end is displaced in the downward direction as shown by one-dot chain line in the figure.

Then, the piezoelectric actuator 1 is used as various driving sources, such as a needle selecting driver of knitting needles of a knitting machine, by utilizing a bending motion by dint of such a piezoelectric phenomenon.

Specifically, as shown in Fig.8, the aforementioned plural piezoelectric actuators 1 (shown by dividing into 1a, 1b, 1c, 1d, 1e, 1f, 1g, and 1h in the figure) are arranged on a side wall 9a in a long and narrow insulating box-shaped case 9 in parallel to each other at prescribed intervals apart from one another, with the one ends supported in an open-sided shape and the other ends as the open end inserted into operation holes 11 formed on the side wall 9b opposed to the side wall 9a in the case 9 with a certain play. Then, operation pieces 13 as mechanical components fixed to the other ends are protruded with a certain play from the operation holes 11.

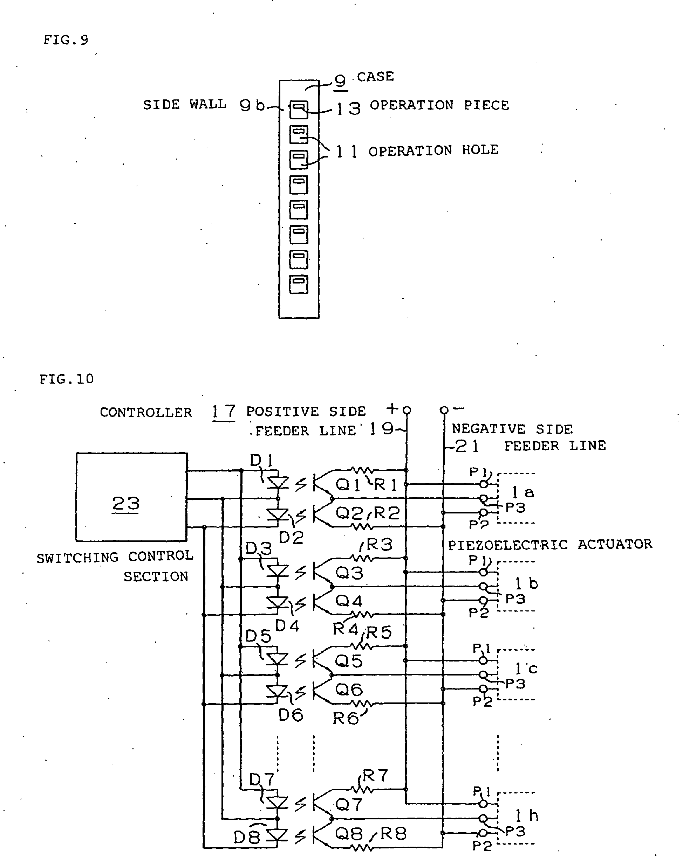

All of the plural piezoelectric actuators 1a to 1h (including the operation pieces 13) supported by the case 9 are the same actuators, and Fig. 9 is a view of the case 9 viewed from the side of the side wall 9b of the case 9, specifically from the tip end side of the operation piece 13.

When a positive/negative direct current drive voltage is applied from a power supply section 15 to such plural piezoelectric actuators 1a to 1h through a controller 17, each of the piezoelectric actuators 1a to 1h is bent and the operation pieces 13 protruding from the operation holes 11 of the case 9 are displaced. This contributes to moving a selecting needle lever not shown (mechanism component) by means of the operation pieces 13.

Then, when the controller 17 switches and selects the drive voltage applied to the plural piezoelectric actuators 1a to 1h, the piezoelectric actuators 1a to 1h can be used as a needle selecting driver of the knitting needles of the knitting machine, for example.

A general patent document according to such a kind of piezoelectric actuator includes a patent document 1 (Japanese Patent Laid Open No.5-302251).

Further, the structure as shown in Fig.10 is given as an example of the structure of selectively controlling the drive voltage applied to the plural piezoelectric actuators 1a to 1h by the controller 17.

Specifically, phototransistors Q1 and Q2, Q3 and Q4, Q5 and Q6, Q7 and Q8, which are connected in series respectively, are disposed corresponding to the plural piezoelectric actuators 1a to 1h. A collector of one of the phototransistors Q1 is connected to the phototransistor Q2 through a resistor R1 from a positive side feeder line 19, and an emitter of the other phototransistor Q2 is connected to a negative side feeder line 21 through a resistor R2.

The positive terminal P1 in the piezoelectric actuator 1a is connected to the positive side feeder line 19, the negative terminal P2 is connected to the negative side feeder line 21, and joints of the phototransistors Q1 and Q2 are connected to common terminal P3 of the piezoelectric actuator 1a.

Similarly, the phototransistors Q3 to Q8 are also connected to the positive side and negative side feeder lines 19 and 21 through resistors R3 to R8, and the piezoelectric actuators 1b to 1d are also connected to the joints of the phototransistors Q3 to Q8 and the positive side and negative side feeder lines 19 and 21.

In addition, light emitting diodes D1 and D2, D3 and D4, D5 and D6, and D7 and D8 connected in series are disposed in proximity to and corresponding to the photo transistors Q1 and Q2, Q3 and Q4, Q5 and Q6, and Q7 and Q8 connected in series.

The light emitting diodes D1 to D8 are emitted by selectively being energized by a switching control section 23, and the driver of the aforementioned piezoelectric actuators is thus formed.

In Fig.10, the aforementioned controller 17 is formed by the phototransistors Q1 to Q8, light emitting diodes D1 to D8, and the switching control section 23.

Note that in Fig.10, the light emitting diodes D1 to D8 are connected by one line from the switching control section 23. However, actually the light emitting diodes D1 to D8 are connected by individual wiring corresponding to the light emitting diodes D1 to D8. Such wiring is simplified in Fig.8 so as to be easy to understand.

Then, for example, when the driver of the piezoelectric actuator is used in the needle selecting driver, for example, and the piezoelectric actuator 1a out of the plural piezoelectric actuators 1a to 1h is on-controlled, the open end is displaced in the upward direction through the conduction control of only light emitting diode D1 selectively by the switching control section 23. Meanwhile, the tip end is displaced in the downward direction through the conduction control of only light emitting diode D2 selectively.

Similarly, in the other piezoelectric actuators 1b to 1h also, the tip end is displaced through the conduction control of only either of the light emitting diodes D3 or D4, D5 or D6, and D7 or D8, and after a specified on-control period has passed, all the piezoelectric actuators 1a to 1h are simultaneously off-controlled.

In addition, in the aforementioned driver of the piezoelectric actuator, as shown in Fig.7B, the piezoelectric sheets 5 and 7 function as a kind of capacitors C1 and C2. Therefore, even when the drive voltage is applied to the piezoelectric sheets 5 and 7 of each of the piezoelectric actuators 1a to 1h to on-control the plural piezoelectric actuators 1a to 1h, any large current is prevented from running over the on-control period. Therefore, it is considered that power saving of the overall device is easily achieved.

In addition, in the driver of the piezoelectric actuators thus constituted, the resistors R1 to R8 connected between the phototransistors Q1 to Q8 and the positive side and negative side feeder lines 19 and 21 have a current limit function to suppress a drive current flowing through the phototransistors Q1 to Q8 so as not to increase the power consumption for the entire driver due to increased drive current, which occurs when one of the phototransistors is switched to the other in the phototransistors Q1 and Q2, Q3 and Q4, Q5 and Q6, and Q7 and Q8, thereby causing both of the phototransistors Q1 and Q2, Q3 and Q4, Q5 and Q6, and Q7 and Q8 to be temporarily conducted or a rapid current change to occur, resulting in a large drive current.

However, in the driver of the aforementioned piezoelectric actuators, a large drive current is inhibited from running through the piezoelectric sheets 5 and 7, which constitute the plural piezoelectric actuators 1a to 1h, during the on-control period thereof. However, in the piezoelectric sheets 5 and 7, namely, in each of the piezoelectric actuators 1a to 1h, the capacitors C1 and C2 are equivalently formed. In addition, capacitance of such capacitors has a large level of about 150 to 600nF, and therefore a large drive current is easy to run through the piezoelectric sheets 5 and 7 immediately after the on-control of the piezoelectric actuators 1a to 1h.

Then, with any one of the piezoelectric actuators 1a to 1h on-controlled, when another one of the piezoelectric actuators 1a to 1h is duplicately on-controlled, flow of a large drive current occurs frequently, to easily raise power consumption of the overall driver.

In order to avoid above situation, it needs to cope with increase in the drive current by a treatment such as making the wiring of the feeder line thick, which causes easy increase in cost.

The present inventors carefully study the piezoelectric actuators 1a to 1h, and the function and an equivalent circuit thereof. As a result, the present inventors focus on the point that the piezoelectric actuators 1a to 1h have the function as capacitors equivalently, and in addition each of the piezoelectric actuators 1a to 1h is electrically connected in parallel, and the piezoelectric sheets 5 and 7 of the piezoelectric actuators 1a to 1h, which are off-controlled, are discharged. US 2001/0035696 A1 teaches charge transfer between the two piezoelectric elements of a bimorph actuator or between different linear extension/contraction actuators.

In order to solve the aforementioned problem, the present invention is provided, and an object of the present invention is to provide the driver of the piezoelectric actuator capable of suppressing the power consumption of an overall device, by drastically reducing the drive current, during on/off switching control in the driver for driving the plural actuators.

## Disclosure of the Invention

In order to solve the aforementioned problem, the present invention provides plural actuators in each of which a first and a second piezoelectric sheet are attached to opposed surfaces of a plate interposed between the first and the second piezoelectric sheets, comprising:

plural actuators mechanically moving a mechanical component directly or indirectly connected to each of the piezoelectric actuators;

a positive side feeder line <u>directly connected in common</u> to the side of the first piezoelectric sheets opposite to the side attached to the plate;

a negative side feeder line <u>directly connected in common</u> to the side of the second piezoelectric sheets opposite to the side attached to the plate; and

a controller selectively applying a positive or a negative drive voltage to the first and the second piezoelectric sheets so that the piezoelectric sheets are on-controlled and charged, by connecting the positive side or the negative side feeder line to the plate side of the first or the second piezoelectric sheets.

In addition, the controller has a function to off-control the drive voltage applied to the first or the second piezoelectric sheet of the piezoelectric actuator selectively on-controlled, and simultaneously with this, on-controls the drive voltage to be applied to the first or the second piezoelectric sheet of the piezoelectric actuator to be selectively on-controlled next, so that the piezoelectric sheet of the piezoelectric actuator thus on-controlled next is charged. <u>Then, the first or the second piezoelectric sheet of the on-controlled piezoelectric actuator is directly charged by discharging current from the first or the second piezoelectric sheet of the off-controlled piezoelectric actuator, through the positive side or the negative side feeder line.</u>

**Brief description of the drawings**

Fig.1 is a block circuit diagram showing an embodiment relating to a driver of a piezoelectric actuator according to the present invention.

Fig.2 is a waveform chart explaining a switching operation of the driver of the piezoelectric actuator according to the present invention.

Fig.3 is a schematic equivalent circuit diagram of the piezoelectric actuator of the present invention.

Fig.4 is a circuit diagram for explaining the operation of the piezoelectric actuator of the present invention.

Fig.5 is a view for explaining the operation of the piezoelectric actuator of the present invention.

Fig.6 is a block circuit diagram showing other embodiments relating to the driver of the piezoelectric actuator according to the present invention.

Fig.7 is a sectional view A and an equivalent circuit diagram B showing a general constitution of the piezoelectric actuator.

Fig.8 is a sectional view showing a constitution example to which the piezoelectric actuator is applied.

Fig.9 is a side view of an essential part of Fig.8.

Fig.10 is a block circuit diagram showing the driver of a conventional piezoelectric actuator.

**Best Modes for Carrying Out the Invention**

Embodiments of the present invention will be explained with reference to the drawings of the present invention hereunder. Note that the parts identical to those in the conventional example are assigned the same numerals without further explanation.

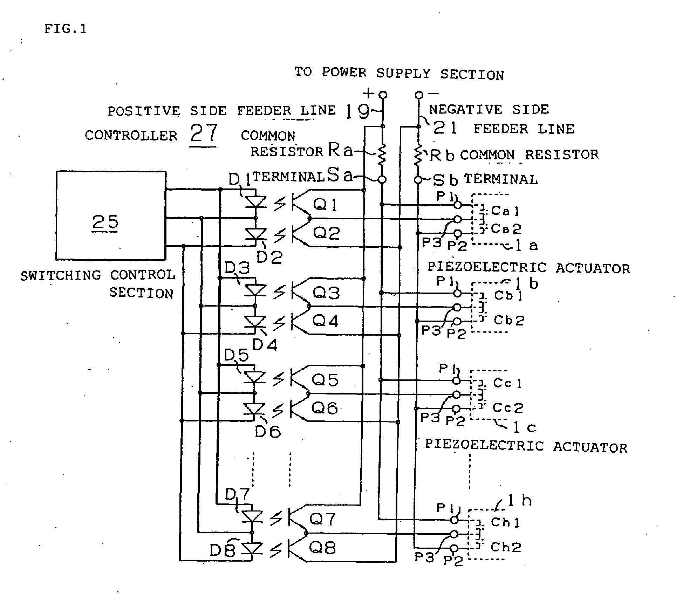

Fig.1 is a block diagram showing an embodiment relating to a driver of a piezoelectric actuator according to the present invention.

In Fig. 1, each of the plural piezoelectric actuators 1a, 1b 1c, 1d, 1e, 1f, 1g, and 1h is composed of a conductive plate 3, and a piezoelectric sheet (first piezoelectric sheet) 5 and a piezoelectric sheet (second piezoelectric sheet) 7 attached to the opposed surfaces of the conductive plate 3, as shown in Fig. 7A for example, wherein electrodes 5a and 7a are provided on the opposed surfaces not touching the plate 3 of each of the piezoelectric sheets 5 and 7, with the plate 3 serving as a common electrode of each of the piezoelectric sheets 5 and 7.

The electrodes 5a and 7a of the piezoelectric sheets 5 and 7 are connected to a positive terminal P1 and a negative terminal P2, and the plate 3 is connected to a common terminal P3, so as to be supported by a box-shaped case 9 (not shown in Fig.1) in an open-sided shape, as shown in Fig.8.

Note that in Fig.1, the piezoelectric actuators 1a to 1h are not shown, however they are formed in the same way as the piezoelectric actuator 1 of Fig.7.

As shown in Fig. 1, a positive side feeder line 19 and a negative side feeder line 21 are extended from a power supply section 15, serving as lines to supply a positive DC power supply of about + 50 V to + 100 V, and a negative DC power supply of about - 50 V to - 100 V. Then, common resistors Ra and Rb for current limitation are inserted and connected in series in the middle thereof, respectively.

Phototransistors Q1 and Q2, Q3 and Q4, Q5 and Q6, and Q7 and Q8, in which emitters and collectors are mutually connected in series, are disposed corresponding to the piezoelectric actuators 1a to 1h.

Each collector of each of the phototransistors Q1, Q3, Q5, and Q7 is directly connected to the positive side feeder line 19 on the side of the power supply section of the common resistor Ra, not through the common resistor Ra.

Each emitter of the phototransistors Q2, Q4, Q6, and Q8 is connected to the negative side feeder line 21 on the side of the power supply section of the common resistor Rb.

Joints of the phototransistors Q1 and Q2, Q3 and Q4, Q5 and Q6, and Q7 and Q8 are connected to common terminals P3 of the piezoelectric actuators 1a, 1b 1c, to 1h.

Positive terminals P1 of the piezoelectric actuators 1a, 1b, 1c, to 1h are connected to the terminal Sa of the common resistor Ra of the positive side feeder line 19 on the side opposite to the power supply section. Meanwhile, negative terminals P2 of the piezoelectric actuators 1a, 1b, 1c to 1h are connected to a terminal Sb of the common resistor Rb of the negative side feeder line 21 on the side opposite to the power supply section.

Designation marks Ca1 and Ca2 in Fig.1 correspond to equivalent capacitors formed in the piezoelectric actuator 1a (corresponding to C1 and C2 in Fig.7B). The same can be said for the designation marks Cb1, Cb2, Cc1, Cc2, and Ch1, Ch2.

The light emitting diodes D1 and D2, D3 and D4, D5 and D6, and D7 and D8 are connected in series in a forward direction. The light emitting diode D1 and the phototransistor Q1, the light emitting diode D2 and the phototransistor Q2, the light emitting diode D3 and the phototransistor Q3, the light emitting diode D4 and the phototransistor Q4, the light emitting diode D5 and the phototransistor Q5, the light emitting diode D6 and the phototransistor Q6, the light emitting diode D7 and the phototransistor Q7, and the light emitting diode D8 and the phototransistor Q8, are correspondingly disposed in proximity to each other, respectively.

The light emitting diodes D1 and D2, D3 and D4, D5 and D6, and D7 and D8 are connected to a switching control section 25. Then, by this switching control section 25, any one of the light emitting diodes D1 to D8 is switched and conducted to emit light.

The present invention is characterized by timing of sequentially selectively conduct-control of the plural light emitting diodes D1 to D8, by the switching control section 25.

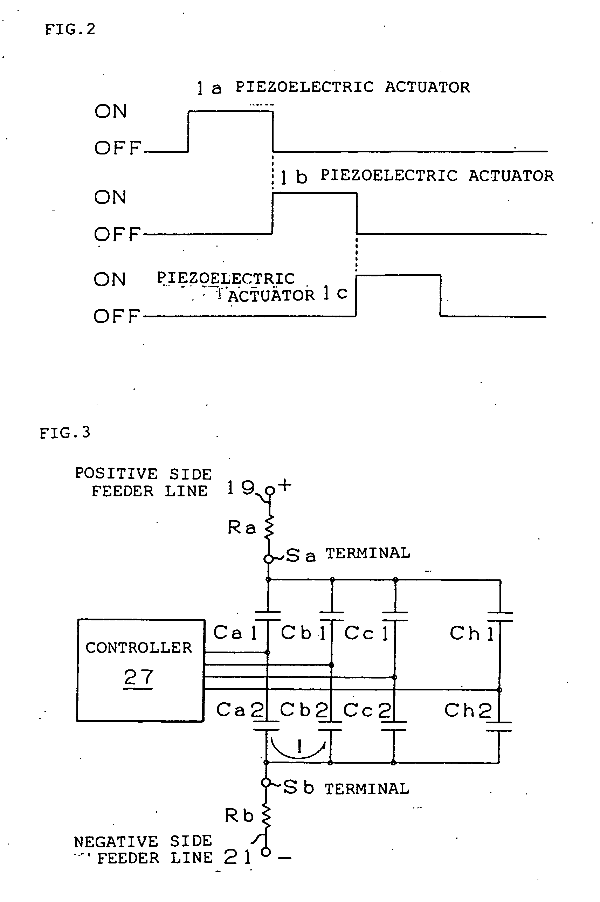

Specifically, as shown in Fig.2, for example, the switching control section 25 controls the plural piezoelectric actuators 1a to 1h by switching, in such a manner that the piezoelectric actuator 1a is on-controlled by applying the drive voltage thereto, and after a specified elapsed period of time previously set, the piezoelectric actuator 1a (more correctly piezoelectric sheets 5 and 7) is off-controlled by turning off the drive voltage applied to the piezoelectric sheets subjected to on-control, simultaneously with this, the next piezoelectric actuator 1b is on-controlled by applying the drive voltage thereto, then simultaneously with this, the drive voltage applied to the piezoelectric actuator 1b is off-controlled, and simultaneously with this, further next piezoelectric actuator 1c is on-controlled by applying the drive voltage thereto, and thereafter onward, such a control of the drive voltage is sequentially repeated.

Designation mark 27 in Fig.1 indicates the controller 27 constituted of the aforementioned phototransistors Q1 to Q8, the light emitting diodes D1 to D8, and the switching control section 25. In the controller 27, as described above, the switching control section 25 has a function to sequentially selectively switch and control the piezoelectric sheets 5 and 7 of each of the piezoelectric actuators 1a to 1h, so that the drive voltage is applied thereto from the feeder lines 19 and 21.

A connection structure of the equivalent capacitors Ca1 to Ch2 of the aforementioned piezoelectric actuators 1a to 1h and the controller 27 is shown in Fig.3.

In Fig.1 also, the light emitting diodes D1 to D8 are connected by one line from the switching control section 25. However, actually the light emitting diodes D1 to D8 are connected by individual wiring so that the light emitting diodes D1 and D2, D3 and D4, D5 and D6, and D7 and D8 are corresponded. Then, in the same way as Fig.10, any one of the light emitting diodes D1 to D8 is selected to allow emission control.

Then, specifically, when only light emitting diode D1 is selectively conduct-controlled by the operation of the switching control section 25, the phototransistor Q1 is on-operated by receiving the light from the light emitting diode D1, and the piezoelectric sheet 5 (not shown in Fig.1. Similarly not shown hereafter) of the piezoelectric actuator 1a is short-circuited by the positive drive voltage.

Meanwhile, the positive and negative drive voltages are applied to both sides of the piezoelectric sheet 7 of the piezoelectric actuator 1a (not shown in Fig.1. Similarly not shown hereafter), and the capacitor Ca2 is thereby charged, and the open end (operation piece 13) of the piezoelectric actuator 1a is displaced in the upward direction.

Then, the phototransistor Q1 is off-operated by the off-control of the light emitting diode D1 by the switching control section 25, and the piezoelectric sheet 7 of the piezoelectric actuator 1a is discharged, and the open end thereof (operation piece 13) is returned to an original position.

When only light emitting diode D2 is selectively conduct-controlled, the phototransistor Q2 is on-operated by receiving the light from the light emitting diode D2, and the piezoelectric sheet 7 of the piezoelectric actuator 1a is short-circuited by the negative drive voltage.

Meanwhile, the capacitor Ca1 is charged by applying the positive and negative drive voltages to both sides of the piezoelectric sheet 5 of the piezoelectric actuator 1a, and the open end thereof (operation piece 13) is displaced in the downward direction.

Then, the phototransistor Q2 is off-operated by the off-control of the light emitting diode D2, and the open end thereof (operation piece 13) is returned to the original position, simultaneously with discharge of the piezoelectric sheet 5 of the piezoelectric actuator 1a.

Next, the operation of the driver of the piezoelectric actuators thus constituted will be explained, when the piezoelectric actuators 1a to 1h are on-controlled in this order, for example.

When the switching control section 25 selectively conduct-control only light emitting diode D1, the phototransistor Q1 is on-operated and the positive side drive voltage is applied from the feeder line 19 to the piezoelectric actuator 1a through the common resistor Ra, thereby short-circuiting the piezoelectric sheet 5 of the piezoelectric actuator 1a by the positive drive voltage.

Meanwhile, the positive and negative drive voltages are applied to both sides of the piezoelectric sheet 7 of the piezoelectric actuator 1a, and the capacitor Ca2 is thereby charged.

The switching control section 25 functions to off-control the light emitting diode D1, after elapsed period of time of driving the piezoelectric actuator 1a, and simultaneously with this, on-operate the phototransistor Q3 by selectively conduct-controlling only light emitting diode D3.

Therefore, the capacitor Ca2 of the piezoelectric actuator 1a is discharged in association with off-control of the piezoelectric actuator 1a, and meanwhile, the capacitor Cb2 is charged by short-circuiting the piezoelectric sheet 5 of the piezoelectric actuator 1b by the positive drive voltage, thereby applying the positive and negative drive voltages on both sides of the piezoelectric sheet 7 of the piezoelectric actuator 1b.

At this time, as shown in Fig. 3, the piezoelectric sheet 7 (Capacitor Cb2) is charged, while discharging current I mainly from the piezoelectric actuator 1a (capacitor Ca2) runs to the piezoelectric sheet 7 (capacitor Cb2) of the piezoelectric actuator 1b through the negative side feeder line 21. Thereafter onward, this is sequentially repeated from the next actuators 1c to 1h.

Specifically, the piezoelectric actuator 1a is on-controlled to charge the capacitor Ca2, and the piezoelectric actuator 1a is off-controlled to discharge the capacitor Ca2 to produce discharging current I. Then, by this discharging current I, the capacitor Cb2 of the piezoelectric actuator 1b to be on-controlled next is charged.

Then, the piezoelectric actuators 1a to 1h to be on-controlled is sequentially charged by the discharging current from the capacitor Ca2 of the piezoelectric actuator 1a which is off-operated immediately before on-operated.

For this reason, during on/off switch control, current running through the common resistors Ra and Rb is made to be close to "zero" or extremely small, thus not too requiring power supply from the positive or negative side feeder lines 19 and 21 by on/off switching.

Hereafter, by using formulas or the like, consideration is given to the reason for not too requiring power supply from the positive or negative side feeder lines 19 and 21, by the discharging current from the capacitors Ca1 to Ch2 of any one of the piezoelectric actuators 1a to 1h to charge the capacitors Ca1 to Ch2 of any other one of the piezoelectric actuators 1a to 1h.

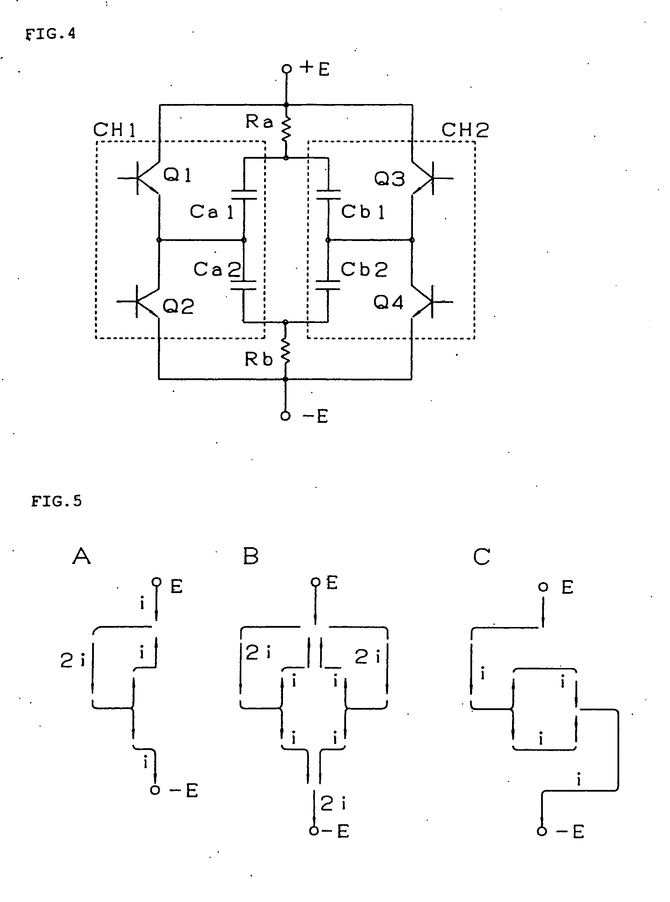

In order to simplify the consideration, two-sheet constitution to drive only piezoelectric actuators 1a and 1b in Fig.1 is considered as shown in Fig.4.

Here, the capacitors Ca1 and Ca2 of the piezoelectric actuator 1a and the phototransistors Q1 and Q2 selectively on/off controlling the capacitors Ca1 and Ca2 are defined as a channel CH1, and the capacitors Cb1 and Cb2 of the piezoelectric actuator 1b and the phototransistors Q3 and Q4 selectively on/off controlling the capacitors Cb1 and Cb2 are defined as a channel CH2.

Such channels CH1 and CH2 are independently provided, and either of the phototransistor Q1 or Q2, or the phototransistor Q3 or Q4 is on-operated, and the energy balance in this case is shown as follows.

Specifically, energy obtained by subtracting "dissipated energy at resistors Ra and Rb" and "dissipated energy due to offset of the holding energy polarity" from "inputted energy" from a power source E, becomes a capacitor holding energy in the capacitors Ca1 to Cb2.

In a case of one-sheet constitution of the piezoelectric actuator 1a, if the operation of the phototransistors Q1 and Q2 are taken into consideration, a current route in Fig.4 is shown in Fig.5A, where current i is expressed by formula 1.

[Formula 1]

$$i = \frac{2E}{R} e^{-\frac{t}{CR}}$$

An amount of energy dissipation at the resistors Ra and Rb is expressed by formula 2.

[Formula 2]

$$Wu + Wd = 2\int i^2 R \, dt = 4CE^2$$

An amount of energy input from the power source E is expressed by formula 3.

[Formula 3]

$$2E\int i \, dt = 4CE^2$$

In addition, in the case of two-sheet constitution of the piezoelectric actuators 1a and 1b, when the operation of the phototransistors Q1 and Q3, in which the current i is allowed to run in the same direction, is taken into consideration, the current rout of Fig.4 is shown in Fig.5B, and the current i is expressed by formula 4.

[Formula 4]

$$i = \frac{E}{R} e^{-\frac{t}{2CR}}$$

An amount of energy dissipation at the resistors Ra and Rb is expressed by formula 5.

[Formula 5]

$$Wu + Wd = 2\int 2\,i^2\,R\,dt = 8CE^2$$

An amount of energy input from the power source E is expressed by formula 6.

[Formula 6]

$$2E\int (2\,i)\,dt = 8CE^2$$

Further, in the case of two-sheet constitution of the piezoelectric actuators 1a and 1b, when the operation of the phototransistors Q1 to Q4, in which the current i is allowed to run in an opposite direction, is taken into consideration, the current route is shown in Fig.5C, and the current i is expressed by formula 7.

[Formula 7]

$$i = \delta(t) \quad \left(\frac{1}{C}\int i\,dt = 2E : \text{インパルス}\right)$$

The current i does not run through the resistors Ra and Rb.
Accordingly, the amount of energy dissipation at the resistors Ra and Rb is close to "zero", and the amount of energy input from the power source E is expressed by formula 8.

[Formula 8]

$$2E\int (2\,i)\,dt = 2E \cdot 2 \cdot 2CE = 8CE^2$$

As described above, from the consideration using the formulas, it is found that the energy during on/off switch control of the piezoelectric actuators 1a and 1b moves directly between the piezoelectric actuators 1a and 1b not through the resistors Ra and Rb. The same can be said for the piezoelectric actuators 1a to 1h.
Then, energy movement between the piezoelectric actuators 1a and 1b during on/off switch control is increased, thereby improving a transient characteristic and improving on/off switching performance of the overall device, and in addition, drastically reducing the amount of energy dissipation (amount of heat generation) at the resistors Ra and Rb, and the power consumption of the overall device can be reduced.

In this way, the driver of the piezoelectric actuator of the present invention has the plural piezoelectric actuators 1a to 1h, each of which is composed of a plate 3 and piezoelectric sheets 5, 7 attached to the opposed surfaces of the plate interposed between the piezoelectric sheets 5 and 7, and also has the controller 27 which functions to charge the piezoelectric sheets 5 and 7 by selectively on-controlling either of them by connecting the electrodes 5a and 7a of the opposed surfaces of the plate 3, of the piezoelectric sheets 5 and 7 of each of the piezoelectric actuators 1a to 1h, to the positive side or the negative side feeder line 19, 21, and in this condition, by applying the drive voltage to the piezoelectric sheets 5 and 7 of any one of the piezoelectric actuators 1a to 1h which is selected to be on-controlled, from the positive side or the negative side feeder line 19 or 21 on the side of the plate 3.

In addition, the controller 27 has the function to off-control the drive voltage applied to the piezoelectric sheets 5 and 7 of any one of the piezoelectric actuators 1a to 1h which is selected to be on-controlled, and simultaneously with this, charge the piezoelectric sheets 5 and 7 of any other one the piezoelectric actuators 1a to 1h to be on-controlled next by turning on the drive voltage applied thereto.

Therefore, for example, the discharging current runs when the piezoelectric actuator 1a is subjected to on-control to charge the capacitor Ca2, and the piezoelectric actuator 1a is subjected to off-control to discharge the capacitor Ca2, and by this discharging current, the capacitor Cb2 of the piezoelectric actuator 1b to be on-controlled next is charged.

Any one of the piezoelectric actuators 1a to 1h to be on-controlled is sequentially charged by the discharging current from any one of the capacitors Ca1 to Ch2 of any one of the piezoelectric actuators 1a to 1h which is off-controlled immediately before being on-controlled. Therefore, the charging current which is apt to be increased at on/off switching needs not to be supplied so much from the positive or negative side feeder lines 19 and 21.

Accordingly, in the driver driving the plural piezoelectric actuators 1a to 1h, the drive current during on/off control of the piezoelectric actuators 1a to 1h can be drastically reduced, and the power consumption of the overall device can thereby be suppressed low.

In addition, resistors R1 to R8 for current limitation inserted per every piezoelectric actuator 1a to 1h can be reduced to the common resistors Ra and Rb. Moreover, such resistors R1 to R8 with small sizes can be used at a low cost and wiring is simplified, which achieves a cost reduction and improved productivity. Note that the number of components can also be reduced by omitting the resistors Ra and Rb for current limitation.

In the present invention, any one of the piezoelectric actuators 1a to 1h is off-controlled to produce discharging current, and by this discharging current from the capacitor, any other one of the piezoelectric actuators 1a to 1h to be driven next is on-controlled. Therefore, it is preferable that on-control timing of any other one of the piezoelectric actuators 1a to 1h to be on-controlled next is simultaneously with or immediately after off-control of any one of the piezoelectric actuators 1a to 1h subjected to on-control. In transition, the effect is decreased by half after charging to some extent the piezoelectric actuators 1a to 1h subjected to on-control.

The controller 27 of the present invention has the function to on-control the piezoelectric sheets 5 and 7 of any other one of the piezoelectric actuators 1a to 1h to be driven next, so that the drive voltage is applied thereto at a timing of off-controlling the drive voltage applied to the piezoelectric sheets 5 and 7 of any one of the piezoelectric actuators 1a to 1h.

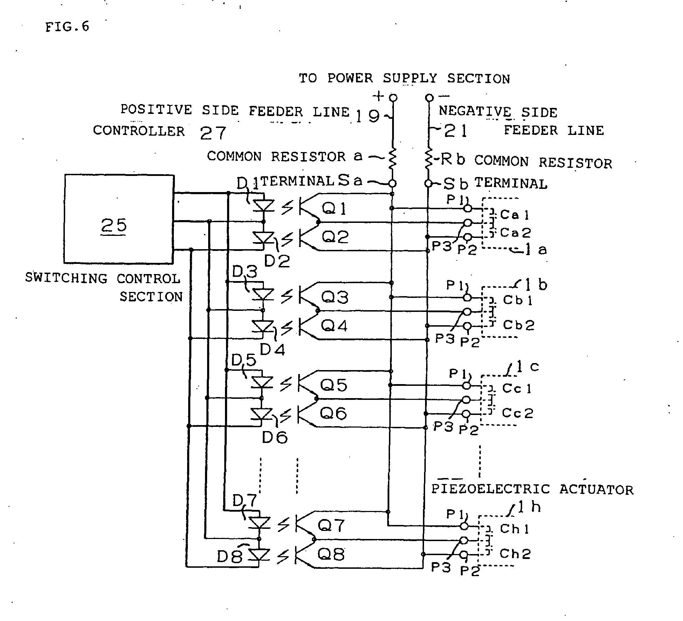

Incidentally, as shown in Fig.6, the driver of the piezoelectric actuator according to the present invention may also be constituted by connecting the phototransistors Q1, Q3, Q5, and Q7 to the positive side feeder line 19 through the terminal Sa of the common resistor Ra on the side opposite to the power supply section, or by connecting the phototransistors Q2, Q4, Q6, and Q8 to the negative side feeder line 21 through the terminal Sb of the common resistor Rb on the side opposite to the power supply section. Other constitution is the same as that of Fig.1, and the same effect can be obtained.

As described above, when the phototransistors Q1 to Q8 are connected to the positive side and negative side feeder lines 19 and 21 through the common resistors Ra and Rb on the side of the power supply section, the influence of fluctuation in the power supply voltage to the phototransistors Q1 to Q8 is diminished during on/off switch control of the phototransistors Q1 to Q8 (piezoelectric actuators 1a to 1h), and preferably a stable operation can thereby be easily realized.

The aforementioned each of the piezoelectric actuators 1a to 1h is arbitrarily constituted, and for example, may be composed of only piezoelectric plates 3 and 5, or may have plural piezoelectric plates 3 and 5 and the plate 3 may be laminated, and also the supporting body is not limited to the constitution of the aforementioned case 9 of Fig.8.

The present invention is useful for the constitution of sequentially switching and controlling the piezoelectric sheets directly connected in common from the positive side or negative side feeder lines 19 and 21 directly, or sequentially controlling and switching the capacitors Ca1, Cb1, Cc1, and Ch1, or the capacitors Ca2, Cb2, Cc2, and Ch2.

According to the present invention, the switching mechanism of the controller 27 for switching the drive power source from the feeder lines to the plural piezoelectric actuators 1a to 1h, is not limited to the aforementioned combination of the light emitting diodes D1 to D8 and the phototransistors Q1 to Q8, but may be a contactless switch by only transistor for turning on and off the power source, and the switching control section 25 may be formed in accordance with the switching mechanism.

Note that when the light emitting diodes D1 to D8 are combined with the phototransistors Q1 to Q8, an insulating state between the feeder lines 19, 21, and the controller 17 side is easily formed and a stable operation can thereby be realized.

The driver of the piezoelectric actuator according to the present invention is not limited to the driver for driving the knitting needles of the knitting machine as described above, but applicable as a drive source mechanically moving a mechanical component directly or indirectly connected to each of the plural piezoelectric actuators having piezoelectric sheets, such as an ink jet drive source and a dot wire drive source in a printer.

FIG.1
TO POWER SUPPLY SECTION

19    POSITIVE SIDE FEEDER LINE
21    NEGATIVE SIDE FEEDER LINE
25    SWITCHING CONTROL SECTION
27    CONTROLLER

COMMON RESISTOR Ra
COMMON RESISTOR Rb
TERMINAL Sa
TERMINAL Sb
PIEZOELECTRIC ACTUATOR

FIG.2

1a    PIEZOELECTRIC ACTUATOR
1b    PIEZOELECTRIC ACTUATOR
1c    PIEZOELECTRIC ACTUATOR

FIG. 3

19    POSITIVE SIDE FEEDER LINE
21    CONTROLLER
Sa    TERMINAL
Sb    TERMINAL
27    CONTROLLER

FIG.6
TO POWER SUPPLY SECTION

19    POSITIVE SIDE FEEDER LINE
21    NEGATIVE SIDE FEEDER LINE

COMMON RESISTOR Ra
COMMON RESISTOR Rb

25    SWITCHING CONTROL SECTION

PIEZOELECTRIC ACTUATOR

FIG.7

1     PIEZOELECTRIC ACTUATOR
P1    POSITIVE TERMINAL
P2    POSITIVE TERMINAL
P3    COMMON TERMINAL

5 PIEZOELECTRIC SHEET
5a ELECTRODE
7 PIEZOELECTRIC SHEET
7a ELECTRODE
3 PLATE

FIG.8

1a, 1b PIEZOELECTRIC ACTUATOR
3,5 PIEZOELECTRIC SHEETS
9 CASE
9a SIDE WALL
9b SIDE WALL
11 OPERATION HOLE
12 OPERATION PIECE
15 POWER SUPPLY SECTION
17 CONTROLLER

FIG.9

9 CASE
9b SIDE WALL
11 OPERATION HOLE
13 OPERATION PIECE

FIG.10

17 CONTROLLER
19 POSITIVE SIDE FEEDER LINE
21 NEGATIVE SIDE FEEDER LINE
23 SWITCHING CONTROL SECTION

PIEZOELECTRIC ACTUATOR

**Claims**

1. A driver for piezoelectric actuators, constituted of plural piezoelectric actuators (1a-1h) in each of which a first and a second piezoelectric sheet (5, 7) are respectively attached to opposed surfaces of a plate (3) interposed between the first and the second piezoelectric sheets, comprising:

   plural actuators mechanically moving a mechanical component (13) directly or indirectly connected to each of the piezoelectric actuators;
   a positive side feeder line (19) directly connected in parallel, to the side of the first piezoelectric sheets opposite to the side attached to the plate;
   a negative side feeder line (21) directly connected in parallel, to the side of the second piezoelectric sheets opposite to the side attached to the plate; and
   a controller (27) to selectively on-control and charge the second or the first piezoelectric sheets by applying a drive voltage to the first and the second piezoelectric sheets, by selectively connecting the positive side or the negative side feeder line to the plate side of the first or the second piezoelectric sheets,

   wherein the controller has a function to off-control the drive voltage applied to the first or the second piezoelectric sheet of each of the piezoelectric actuators selected to be on-controlled, and simultaneously with this, on-control the first or the second piezoelectric sheet of any other one of the piezoelectric actuators to be on-controlled next so as to apply the drive voltage thereto, and a discharging current is allowed to flow from the first or the second piezoelectric sheet of any one of the piezoelectric actuators subjected to off-control, and by this discharging current, the first or the second piezoelectric sheet of any other one of the piezoelectric actuators subjected to on-control is directly charged through the positive side or the negative side feeder line.

**Patentansprüche**

1. Treiber für piezoelektrische Aktuatoren, die mehrere piezoelektrische Aktuatoren (la-1h) aufweisen, in denen jeweils ein erstes und zweites piezoelektrisches Blatt (57) jeweils an gegenüberliegenden Flächen einer Platte (3) angebracht sind, die zwischen dem ersten und zweiten piezoelektrischen Blatt angeordnet ist, mit:

mehreren Aktuatoren, die eine mechanische Komponente (13), die direkt oder indirekt mit jedem der piezoelektrischen Aktuatoren verbunden ist, mechanisch bewegen;
einer positivseitigen Zuleitung (19), die direkt parallel mit der Seite der ersten piezoelektrischen Blätter verbunden ist, die der Seite, die an der Platte angebracht ist, gegenüberliegt;
einer negativseitigen Zuleitung (21), die direkt parallel mit der Seite der zweiten piezoelektrischen Platte verbunden ist, die der Seite, die an der Platte angebracht ist, gegenüberliegt;
einer Steuerung (27) zum selektiven Ein-Steuern und Laden der zweiten oder ersten piezoelektrischen Blätter durch Anlegen einer Treiberspannung an die ersten und zweiten piezoelektrischen Blätter durch selektives Verbinden der positivseitigen oder negativseitigen Zuleitung mit der Plattenseite der ersten oder zweiten piezoelektrischen Blätter,

wobei die Steuerung eine Funktion zum Aus-Steuern der Treiberspannung aufweist, die an das erste oder zweite piezoelektrische Blatt jedes der piezoelektrischen Aktuatoren angelegt ist, die als ein-gesteuert ausgewählt sind, und gleichzeitig damit Ein-Steuern des ersten oder des zweiten piezoelektrischen Blatts eines anderen der piezoelektrischen Aktuatoren, der als nächstes ein-zusteuern ist, so dass die Treiberspannung daran angelegt und einem Entladestrom erlaubt wird, von dem ersten oder dem zweiten piezoelektrischen Blatt von irgendeinem der piezoelektrischen Aktuatoren, die der Aus-Steuerung unterworfen sind, zu fließen, und wobei durch diesen Entladestrom das erste oder das zweite piezoelektrische Blatt irgendeines anderen der piezoelektrischen Aktuatoren, der der Ein-Steuerung unterworfen ist, über die positivseitige oder die negativseitige Zuleitung direkt geladen wird.

**Revendications**

1. Pilote pour actionneurs piézoélectriques, constitué de plusieurs actionneurs piézoélectriques (1a-1h), dans chacun desquels une première et une seconde feuilles piézoélectriques (5, 7) sont fixées respectivement sur les surfaces opposées d'une plaque (3) intercalée entre la première et la seconde feuilles piézoélectriques, comprenant :

plusieurs actionneurs déplaçant mécaniquement un composant mécanique (13) raccordé directement ou indirectement à chacun des actionneurs piézoélectriques ;
une ligne d'alimentation côté positif (19) directement connectée en parallèle au côté des premières feuilles piézoélectriques opposées au côté fixé à la plaque ;
une ligne d'alimentation côté négatif (21) directement connectée en parallèle au côté des secondes feuilles piézoélectriques opposées au côté fixé à la plaque ; et
un dispositif de commande (27) pour commander sélectivement la mise en marche et charger les secondes ou les premières feuilles piézoélectriques, en appliquant une tension de commande aux premières et secondes feuilles piézoélectriques, en connectant sélectivement la ligne d'alimentation côté positif ou la ligne d'alimentation côté négatif au côté plaque des premières ou secondes feuilles piézoélectriques,

dans lequel le dispositif de commande a une fonction de commande d'arrêt de la tension de commande appliquée à la première ou à la seconde feuille piézoélectrique de chacun des actionneurs piézoélectriques sélectionnés pour être commandés en marche et, de manière concomitante, commander la mise en marche de la première ou de la seconde feuille piézoélectrique de l'un quelconque des actionneurs piézoélectriques, qui doit être commandée en marche ensuite de manière à lui appliquer la tension de commande, et on laisse un courant de décharge s'écouler de la première ou de la seconde feuille piézoélectrique de l'un quelconque des actionneurs piézoélectriques soumis à une commande d'arrêt et, par ce courant de décharge, la première ou la seconde feuille piézoélectrique de l'un quelconque des actionneurs piézoélectriques soumis à une commande de mise en marche est directement chargée par la ligne d'alimentation côté positif ou la ligne d'alimentation côté négatif.

FIG.1

TO POWER SUPPLY SECTION

+ o    o −

POSITIVE SIDE FEEDER LINE 1 9    NEGATIVE SIDE
CONTROLLER 27    COMMON    2 1 FEEDER LINE
RESISTOR R a    R b COMMON RESISTOR
D 1 TERMINAL S a    S b TERMINAL
P 1    C a 1
Q 1    C a 2
Q 2    1 a
25    P 3 P 2
D 2    PIEZOELECTRIC ACTUATOR
D 3    P 1    1 b
Q 3    C b 1
Q 4    C b 2
SWITCHING CONTROL    P 3 P 2
SECTION    D 4
D 5    P 1    C c 1
Q 5    C c 2
Q 6    P 3 P 2    1 c
D 6    PIEZOELECTRIC ACTUATOR

D 7    P 1    1 h
Q 7    C h 1
D 8    Q 8    C h 2
P 3 P 2

FIG.2

1 a PIEZOELECTRIC ACTUATOR

ON

OFF

1 b PIEZOELECTRIC ACTUATOR

ON

OFF

ON    PIEZOELECTRIC
         ACTUATOR 1 c

OFF

FIG.3

POSITIVE SIDE
FEEDER LINE  1 9  +

Ra

Sa TERMINAL

CONTROLLER
27

Ca 1  Cb 1  Cc 1      Ch 1

Ca 2  Cb 2  Cc 2      Ch 2

I

Sb TERMINAL

Rb

NEGATIVE SIDE
FEEDER LINE 2 1  −

FIG.4

FIG.5

A            B            C

FIG.6

TO POWER SUPPLY SECTION

POSITIVE SIDE FEEDER LINE 19 ~
CONTROLLER 27
COMMON RESISTOR a ~
D1 TERMINAL Sa ~

NEGATIVE SIDE
~21 FEEDER LINE
~Rb COMMON RESISTOR
Sb TERMINAL

25

SWITCHING CONTROL
SECTION

Q1
Q2
D2
D3
Q3
Q4
D4
D5
Q5
Q6
D6

D7
Q7
D8 Q8

P1
Ca1
Ca2
P3 P2 1a

P1 1b
Cb1
Cb2
P3 P2

P1 1c
Cc1
Cc2
P3 P2

PIEZOELECTRIC ACTUATOR

P1 1h
Ch1
Ch2
P3 P2

FIG.7

PIEZOELECTRIC ACTUATOR

A                                                                              B

PIEZOELECTRIC SHEET

POSITIVE TERMINAL P1                    1          ELECTRODE

+                              5              5a

COMMON TERMINAL

P3

POSITIVE TERMINAL P2                                            3

7          7a

ELECTRODE      PLATE

PIEZOELECTRIC SHEET

C1

C2

FIG.8

PIEZOELECTRIC SHEETS    PIEZOELECTRIC ACTUATOR

CASE 9                  3, 5      1a, 1b

SIDE WALL 9a                                    9b SIDE WALL

13 OPERATION PIECE

11 OPERATION HOLE

1c

1d

1e

1f

13 OPERATION PIECE

11 OPERATION HOLE

+        −

1g    1h

CONTROLLER
17

15 POWER SUPPLY SECTION

FIG.9

9 CASE

SIDE WALL 9 b

1 3 OPERATION PIECE

1 1 OPERATION HOLE

FIG.10

CONTROLLER 1 7 POSITIVE SIDE
FEEDER LINE 1 9

NEGATIVE SIDE
2 1 FEEDER LINE

SWITCHING CONTROL
SECTION

23

D 1
D 2
D 3
D 4
D 5
D 6
D 7
D 8

Q 1 R 1
Q 2 R 2
R 3
Q 3
Q 4
R 4 R 5
Q 5
Q 6
R 6
R 7
Q 7
Q 8 R 8

PIEZOELECTRIC ACTUATOR

P 1
P 3
P 2
1 a

P 1
P 3
P 2
1 b

P 1
P 3
P 2
1 c

P 1
P 3
P 2
1 h

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5302251 A
- US 20010035696 A1